(19) Europäisches Patentamt
European Patent Office
Office européen des brevets

(11) **EP 3 804 468 B1**

(12) **FASCICULE DE BREVET EUROPEEN**

(45) Date de publication et mention
de la délivrance du brevet:
**21.09.2022 Bulletin 2022/38**

(21) Numéro de dépôt: **19790047.5**

(22) Date de dépôt: **17.05.2019**

(51) Classification Internationale des Brevets (IPC):
*H05B 45/59* *(2022.01)*     *H05B 45/20* *(2020.01)*
*H05B 45/40* *(2020.01)*     *H05B 45/48* *(2020.01)*

(52) Classification Coopérative des Brevets (CPC):
**H05B 45/40; H05B 45/20; H05B 45/48; H05B 45/59**

(86) Numéro de dépôt international:
**PCT/FR2019/051136**

(87) Numéro de publication internationale:
**WO 2019/229329 (05.12.2019 Gazette 2019/49)**

(54) **CIRCUIT OPTOELECTRONIQUE COMPRENANT DES DIODES ELECTROLUMINESCENTES**

OPTOELEKTRONISCHE SCHALTUNG MIT LEUCHTDIODEN

OPTOELECTRONIC CIRCUIT COMPRISING LIGHT EMITTING DIODES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **01.06.2018 FR 1800547**

(43) Date de publication de la demande:
**14.04.2021 Bulletin 2021/15**

(73) Titulaire: **Aledia**
**38130 Echirolles (FR)**

(72) Inventeurs:
• **JEANNIN, Olivier**
**38000 Grenoble (FR)**

• **MERCIER, Frédéric**
**38500 Saint Nicolas De Macherin (FR)**
• **RUEDA FONSECA, Pamela**
**38600 Fontaine (FR)**

(74) Mandataire: **Cabinet Beaumont**
**4, Place Robert Schuman**
**B.P. 1529**
**38025 Grenoble Cedex 1 (FR)**

(56) Documents cités:
**WO-A1-2016/108022     WO-A1-2016/198348
US-A1- 2010 096 977     US-A1- 2014 264 402
US-A1- 2014 265 921     US-B2- 8 395 332**

**Description**

Domaine

La présente description concerne un circuit optoélectronique comprenant des diodes électroluminescentes.

Exposé de l'art antérieur

Pour certaines applications, il est souhaitable de pouvoir alimenter un circuit optoélectronique comprenant des diodes électroluminescentes avec une tension alternative, notamment une tension sinusoïdale, par exemple la tension du secteur.

Un inconvénient d'un tel circuit électronique est qu'il peut présenter une variation, généralement périodique, de l'intensité lumineuse émise par le circuit optoélectronique comprenant par exemple une alternance de premières phases d'émission de lumière avec une forte intensité lumineuse et de deuxièmes phases d'émission de lumière avec une faible intensité lumineuse, voire d'absence d'émission de lumière. Un observateur peut percevoir les deuxièmes phases lorsque leur durée est trop importante.

Parmi les critères utilisés pour caractériser la variation de la puissance lumineuse émise par un circuit optoélectronique alimenté avec une tension variable, on peut utiliser le taux de scintillement FR (en anglais flicker ratio). En appelant MAX la valeur maximale de l'intensité lumineuse émise et MIN la valeur minimale de l'intensité lumineuse émise, le taux de scintillement FR est défini par la relation (1) suivante :

$$FR = (MAX - MIN) / (MAX + MIN) \qquad\qquad (1)$$

Le taux de scintillement peut varier de 0 % à 100 %. Il peut être souhaitable que le taux de scintillement soit le plus faible possible.

Les documents WO 2016/198348, US 8 395 332 et US 2014/264402 décrivent des circuits optoélectroniques.

Résumé

Un objet d'un mode de réalisation est de pallier tout ou partie des inconvénients des circuits optoélectroniques comprenant des diodes électroluminescentes décrits précédemment.

Un autre objet d'un mode de réalisation est que le taux de scintillement du circuit optoélectronique est diminué.

Un autre objet d'un mode de réalisation est que le circuit optoélectronique comprend un circuit de commande des diodes électroluminescentes ayant une structure simple.

Un autre objet d'un mode de réalisation est que le circuit optoélectronique est adapté à être alimenté par une tension alternative. L'invention propose un circuit optoélectronique selon la revendication 1.

Ainsi, l'invention prévoit un circuit optoélectronique destiné à recevoir une tension variable contenant une alternance de phases croissantes et décroissantes, le circuit optoélectronique comprenant des diodes électroluminescentes et un dispositif de commutation adapté à permettre ou interrompre la circulation d'un courant dans chaque diode électroluminescente, chaque diode électroluminescente étant recouverte d'une couche photoluminescente, la couche photoluminescente recouvrant au moins l'une des diodes électroluminescentes comprenant au moins un premier luminophore ayant une première constante de déclin et au moins un deuxième luminophore ayant une deuxième constante de déclin différente de la première constante de déclin.

Selon un mode de réalisation, la première constante de déclin est supérieure à 2 ms.

Selon un mode de réalisation, la deuxième constante de déclin est inférieure strictement à 2 ms.

Selon l'invention, les diodes électroluminescentes comprennent une première diode électroluminescente recouverte d'une première couche photoluminescente et une deuxième diode électroluminescente recouverte d'une deuxième couche photoluminescente, le circuit optoélectronique comprenant un premier ensemble comprenant la première diode électroluminescente recouverte de la première couche photoluminescente et adapté à émettre un premier rayonnement et un deuxième ensemble comprenant la deuxième diode électroluminescente recouverte de la deuxième couche photoluminescente et adapté à émettre un deuxième rayonnement, les première et deuxième diodes électroluminescentes étant adaptées à émettre un troisième rayonnement, les première et deuxième couches photoluminescentes comprenant chacune le premier luminophore adapté à absorber en partie le troisième rayonnement et à émettre un quatrième rayonnement différent du troisième rayonnement, l'intensité relative du quatrième rayonnement dans le premier rayonnement étant différente de l'intensité relative du quatrième rayonnement dans le deuxième rayonnement.

Selon un mode de réalisation, la proportion dans l'intensité lumineuse de la lumière émise par le premier ensemble due au premier luminophore est différente d'au moins 2 %, de préférence d'au moins 5 %, de la proportion dans l'intensité lumineuse de la lumière émise par le deuxième ensemble due au premier luminophore.

Selon un mode de réalisation, la première couche photoluminescente comprend au moins le deuxième luminophore adapté à absorber en partie le troisième rayonnement et à émettre un cinquième rayonnement différent du troisième rayonnement.

Selon un mode de réalisation, la deuxième couche photoluminescente comprend au moins le deuxième luminophore.

Selon un mode de réalisation, l'intensité relative du cinquième rayonnement dans le premier rayonnement est différente de l'intensité relative du cinquième rayonnement dans le deuxième rayonnement.

Selon un mode de réalisation, la proportion dans l'intensité lumineuse de la lumière émise par le premier ensemble due au deuxième luminophore est différente d'au moins 2 %, de préférence d'au moins 5 %, de la proportion dans l'intensité lumineuse de la lumière émise par le deuxième ensemble due au deuxième luminophore.

Selon un mode de réalisation, le dispositif de commutation est adapté à connecter les diodes électroluminescentes selon un premier ordre au cours de chaque phase croissante de la tension variable et un deuxième ordre au cours de chaque phase décroissante de la tension variable.

Selon un mode de réalisation, le dispositif de commutation comprend au moins un interrupteur pour chaque diode électroluminescente, le dispositif de commutation étant adapté à transmettre des signaux de commande binaires pour l'ouverture ou la fermeture des interrupteurs.

Selon un mode de réalisation, le circuit optoélectronique comprend une source de courant et, pour chaque diode électroluminescente, l'interrupteur relie la source de courant à ladite diode électroluminescente.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente un schéma électrique d'un mode de réalisation d'un circuit optoélectronique comprenant des diodes électroluminescentes ;
les figures 2 et 3 sont des vues en coupe, partielles et schématiques, de modes de réalisation d'une diode électroluminescente du circuit optoélectronique de la figure 1 ;
la figure 4 est un chronogramme représentant les phases d'émission de lumière des diodes électroluminescentes du circuit optoélectronique de la figure 1 ; et
les figures 5 et 6 représentent des courbes d'évolution en fonction du temps, obtenues par simulation, des intensités lumineuses relatives émises par les diodes électroluminescentes et les luminophores des couches de luminophores du circuit optoélectronique de la figure 1 pour différentes compositions des couches de luminophores.

Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits. Dans la suite de la description, sauf indication contraire, les termes "sensiblement", "environ" et "de l'ordre de" signifient "à 10 % près". De plus, on appelle "signal binaire" un signal qui alterne entre un premier état constant, par exemple un état bas, noté "0", et un deuxième état constant, par exemple un état haut, noté "1". Les états haut et bas de signaux binaires différents d'un même circuit électronique peuvent être différents. En pratique, les signaux binaires peuvent correspondre à des tensions ou à des courants qui peuvent ne pas être parfaitement constants à l'état haut ou bas. Par ailleurs, dans la présente description, on utilise le terme "connecté" pour désigner une liaison électrique directe, sans composant électronique intermédiaire, par exemple au moyen d'une piste conductrice, et le terme "couplé" ou le terme "relié", pour désigner soit une liaison électrique directe (signifiant alors "connecté") soit une liaison via un ou plusieurs composants intermédiaires (résistance, condensateur, etc.).

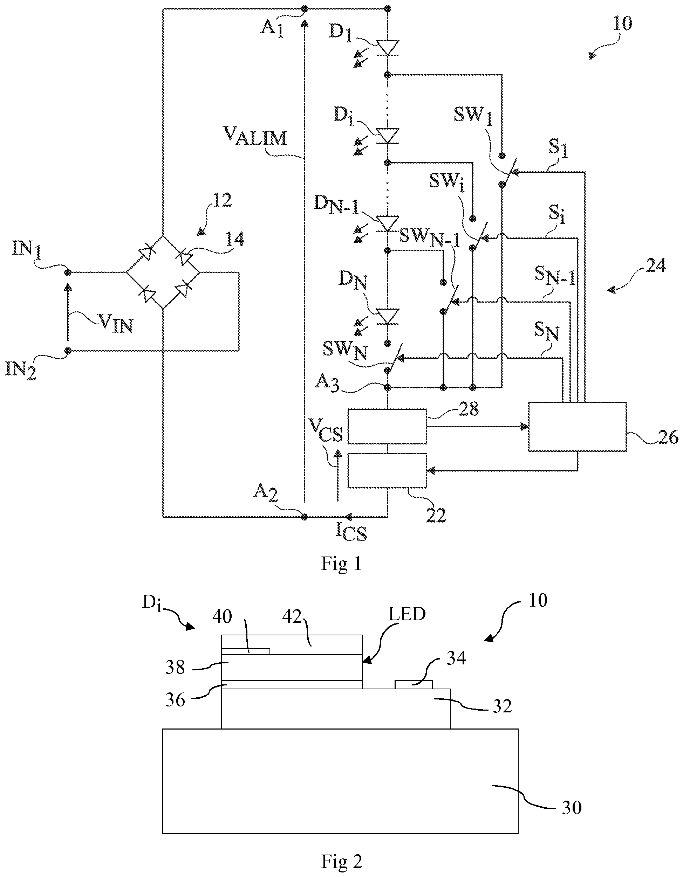

La figure 1 représente un mode de réalisation d'un circuit optoélectronique 10 comprenant des bornes d'entrée $IN_1$ et $IN_2$ entre lesquelles est appliquée une tension alternative $V_{IN}$. Le circuit optoélectronique 10 comprend, en outre, un circuit redresseur 12 comportant un pont de diodes 14, recevant la tension $V_{IN}$ et fournissant une tension $V_{ALIM}$ redressée entre des noeuds $A_1$ et $A_2$. A titre de variante, le circuit 10 peut recevoir directement une tension redressée, le circuit redresseur pouvant alors ne pas être présent. Le potentiel au noeud $A_2$ peut correspondre au potentiel de référence bas, par exemple 0 V, par rapport auquel sont référencées les tensions du circuit optoélectronique 10.

Le circuit optoélectronique 10 comprend N ensembles en série de diodes électroluminescentes élémentaires, appelés diodes électroluminescentes globales $D_i$ dans la suite de la description, où i est un nombre entier variant de 1 à N et où N est un nombre entier compris entre 2 et 200. Chaque diode électroluminescente globale $D_1$ à $D_N$ comprend au moins une diode électroluminescente élémentaire recouverte d'une couche photoluminescente. De préférence, chaque diode électroluminescente globale $D_1$ à $D_N$ est composée de la mise en série et/ou en parallèle d'au moins deux diodes électroluminescentes élémentaires recouvertes d'une couche photoluminescente. Pour chaque diode électroluminescente globale $D_i$, la couche photoluminescente est adaptée à convertir une partie du rayonnement émis par la diode électroluminescente élémentaire ou les diodes électroluminescentes élémentaires de la diode électroluminescente globale $D_i$ en un rayonnement à une autre longueur d'onde. Le rayonnement global émis par la diode électroluminescente globale $D_i$ comprend le rayonnement émis par la diode électroluminescente élémentaire ou les diodes électroluminescentes élémentaires de la diode électroluminescente globale $D_i$ et non converti par la couche photoluminescente et le rayonnement émis par la couche photoluminescente. A titre d'exemple, lorsque la diode électroluminescente élémentaire émet de la lumière bleue et que la couche photoluminescente émet de la lumière jaune, le spectre global de la diode électroluminescente globale $D_i$ peut être proche de celui de la lumière blanche.

Dans le présent exemple, les N diodes électroluminescentes globales $D_i$ sont connectées en série, la cathode de la diode électroluminescente globale $D_i$ étant reliée à l'anode de la diode électroluminescente globale $D_{i+1}$, pour i variant de 1 à N-1. L'anode de la diode électroluminescente globale $D_1$ est reliée, de préférence connectée, au noeud $A_1$. Les diodes électroluminescentes globales $D_i$, i variant de 1 à N, peuvent comprendre le même nombre de diodes électroluminescentes élémentaires ou des nombres différents de diodes électroluminescentes élémentaires.

Le circuit optoélectronique 10 comprend une source de courant 22 dont une borne est reliée au noeud $A_2$ et dont l'autre borne est reliée à un noeud $A_3$. La cathode de la diode électroluminescente globale $D_N$ est reliée au noeud $A_3$. On appelle $V_{CS}$ la tension aux bornes de la source de courant 22 et $I_{CS}$ le courant absorbé par la source de courant 22. Le circuit optoélectronique 10 peut comprendre un circuit, non représenté, qui fournit une tension de référence pour l'alimentation de la source de courant, éventuellement obtenue à partir de la tension $V_{ALIM}$. La source de courant 22 peut avoir une structure quelconque et peut notamment correspondre à une impédance, par exemple une résistance. La source de courant 22 peut être commandée de manière continue par un circuit externe au circuit optoélectronique 10.

Le circuit 10 comprend un dispositif 24 de commutation des diodes électroluminescentes. A titre d'exemple, le dispositif 24 comprend N interrupteurs commandables $SW_1$ à $SW_N$. Chaque interrupteur $SW_i$, i variant de 1 à N, est monté entre le noeud $A_3$ et la cathode de la diode électroluminescente globale $D_i$. Chaque interrupteur $SW_i$, i variant de 1 à N, est commandé par un signal $S_i$ fourni par un module de commande 26. Le module de commande 26 peut, en totalité ou en partie, être réalisé par un circuit dédié ou peut comprendre un microprocesseur ou un microcontrôleur adapté à exécuter une suite d'instructions stockées dans une mémoire. A titre d'exemple, le signal $S_i$ est un signal binaire et l'interrupteur $SW_i$ est ouvert lorsque le signal $S_i$ est dans un premier état, par exemple l'état bas, et l'interrupteur $SW_i$ est fermé lorsque le signal $S_i$ est dans un deuxième état, par exemple l'état haut. Chaque interrupteur $SW_i$ est, par exemple, à base d'au moins un transistor, notamment un transistor à effet de champ à grille métal-oxyde ou transistor MOS, à enrichissement ou à appauvrissement. Le signal $S_i$ est alors le signal de commande de grille du transistor $SW_i$. Selon un mode de réalisation, chaque interrupteur $SW_i$ comprend un transistor MOS à enrichissement à canal N dont le drain est connecté à la cathode de la diode électroluminescente globale $D_i$, dont la source est reliée au noeud $A_3$ et dont la grille reçoit le signal $S_i$. Selon un autre mode de réalisation, l'interrupteur $SW_i$ comprend deux transistors MOS, par exemple à canal N, entre la cathode de la diode électroluminescente globale $D_i$ et le noeud $A_3$, le transistor connecté à la diode électroluminescente globale $D_i$ étant un transistor haute tension monté en cascode et le transistor connecté au noeud $A_3$ étant un transistor basse tension commandé par le signal $S_i$. Ceci permet avantageusement d'augmenter la vitesse de commutation de l'interrupteur $SW_i$.

Le circuit optoélectronique 10 comprend un ou plusieurs capteurs reliés au module de commande 26. Il peut s'agir d'un capteur unique, par exemple un capteur adapté à mesurer la tension $V_{ALIM}$ ou le courant circulant entre les bornes $IN_1$ et $IN_2$, ou de plusieurs capteurs, chaque capteur pouvant être associé à une diode électroluminescente globale $D_i$. A titre d'exemple, on a représenté un seul capteur 28 en figure 1.

Le module de commande 26 est adapté à commander la fermeture ou l'ouverture des interrupteurs $SW_i$, i variant de 1 à N-1, en fonction de la valeur de la tension $V_{ALIM}$ selon une séquence à partir de la mesure d'au moins un paramètre physique, par exemple au moins un courant ou une tension. A titre d'exemple, l'ouverture et la fermeture des interrupteurs $SW_i$ peuvent être commandées par le module de commande 26 à partir des signaux fournis par le capteur 28 ou les capteurs. A titre de variante, l'ouverture et la fermeture des interrupteurs $SW_i$ peuvent être commandées à partir de la mesure de la tension à la cathode de chaque diode électroluminescente globale $D_i$. A titre de variante, l'ouverture et la fermeture des interrupteurs $SW_i$ peuvent être commandées à partir de la mesure de la tension $V_{ALIM}$ ou de la mesure de la tension à la cathode de chaque diode électroluminescente globale $D_i$. Le nombre d'interrupteurs $SW_1$ à $SW_N$ peut varier en fonction de la séquence d'ouverture et de fermeture mise en oeuvre par le module de commande 26. A titre d'exemple, l'interrupteur $SW_N$ peut ne pas être présent. L'ordre de fermeture et d'ouverture des interrupteurs $SW_i$ est fixé par la structure du circuit optoélectronique 10 et se répète pour chaque cycle de la tension d'alimentation $V_{ALIM}$.

Un exemple de fonctionnement du circuit optoélectronique 10 est le suivant en considérant que les interrupteurs

SW$_i$ sont parfaits. Le module de commande 26 est adapté à commander la fermeture ou l'ouverture des interrupteurs SW$_i$, i variant de 1 à N-1, en fonction de la valeur de la tension V$_{CS}$ aux bornes de la source de courant 22. Dans ce but, le circuit de commande 26 peut être adapté à comparer la tension V$_{CS}$ à au moins un seuil. A titre d'exemple, la tension V$_{ALIM}$ fournie par le pont redresseur 12 est une tension sinusoïdale rectifiée comprenant une succession de cycles dans chacun desquels la tension V$_{ALIM}$ augmente depuis la valeur nulle passe par un maximum et diminue jusqu'à la valeur nulle. Au début de chaque cycle, tous les interrupteurs SW$_i$, i variant de 1 à N-1, sont fermés. De ce fait, les diodes électroluminescentes globales D$_2$ à D$_N$ sont court-circuitées et la tension V$_{ALIM}$ se répartit entre la diode électroluminescente globale D$_1$ et la source de courant 22. La tension V$_{ALIM}$ s'élève depuis la valeur nulle. Lorsque la tension aux bornes de la diode électroluminescente globale D$_1$ dépasse sa tension de seuil, la diode électroluminescente globale D$_1$ devient passante et commence à émettre de la lumière. La tension aux bornes de la diode électroluminescente globale D$_1$ est alors sensiblement fixe et la tension V$_{CS}$ continue à augmenter avec la tension V$_{ALIM}$. Lorsque la tension V$_{CS}$ dépasse un seuil, le module 26 commande l'ouverture de l'interrupteur SW$_1$. La tension V$_{ALIM}$ se répartit alors entre les diodes électroluminescentes globales D$_1$ et D$_2$ et la source de courant 22. Lorsque la tension aux bornes de la diode électroluminescente globale D$_2$ dépasse sa tension de seuil, la diode électroluminescente globale D$_2$ devient passante et commence à émettre de la lumière. La tension aux bornes de la diode électroluminescente globale D$_2$ est alors sensiblement fixe et la tension V$_{CS}$ continue à augmenter avec la tension V$_{ALIM}$. Lorsque la tension V$_{CS}$ dépasse un seuil, le module 28 commande l'ouverture de l'interrupteur SW$_2$. Ces étapes sont répétées jusqu'à ce que l'interrupteur SW$_{N-1}$ soit ouvert. Toutes les diodes électroluminescentes sont alors passantes. Lorsque la tension V$_{ALIM}$ décroît depuis son maximum, les interrupteurs SW$_{N-1}$ à SW$_1$ sont successivement fermés dans cet ordre au fur et à mesure que la tension V$_{ALIM}$ décroît, par exemple chaque fois que la tension V$_{CS}$ passe en dessous d'un seuil.

Les diodes électroluminescentes élémentaires du circuit optoélectronique 10 peuvent être à structure bidimensionnelle ou à structure tridimensionnelle. On appelle couche active d'une diode électroluminescente élémentaire la couche depuis laquelle est émise la majorité du rayonnement électromagnétique fourni par la diode électroluminescente. La diode électroluminescente est dite à structure bidimensionnelle lorsque la couche active est formée sur une couche semiconductrice plane et la diode électroluminescente est dite à structure tridimensionnelle lorsque la couche active est formée sur au moins un élément semiconducteur tridimensionnel, par exemple un microfil ou un nanofil.

La figure 2 représente un mode de réalisation d'une diode électroluminescente globale D$_i$ du circuit optoélectronique 10, la diode électroluminescente globale D$_i$ comprenant une diode électroluminescente élémentaire LED à structure bidimensionnelle.

Le circuit optoélectronique 10 comprend, du bas vers le haut en figure 2 :

un substrat 30 ;
une première couche semiconductrice 32 d'un matériau semiconducteur dopé d'un premier type de conductivité ;
une première électrode 34 au contact de la première couche semiconductrice 32 ;
une couche active 36 recouvrant la couche semiconductrice 32 ;
une deuxième couche semiconductrice 38 du matériau semiconducteur dopé d'un deuxième type de conductivité opposé au premier type de conductivité, recouvrant la couche active 36 ;
une deuxième électrode 40 au contact de la deuxième couche semiconductrice 38 ; et
une couche photoluminescente 42 recouvrant la deuxième couche semiconductrice 38.

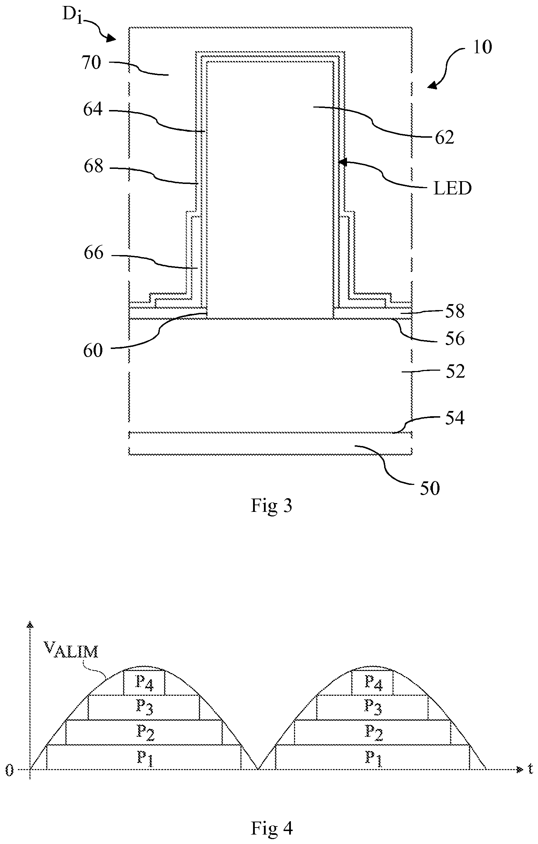

La figure 3 représente un mode de réalisation d'une diode électroluminescente globale D$_i$ du circuit optoélectronique 10, la diode électroluminescente globale D$_i$ comprenant une diode électroluminescente élémentaire LED à structure tridimensionnelle. De tels circuits optoélectroniques sont, par exemple, décrits dans les demandes de brevet français FR 2 995 729 et FR 2 997 558.

Le circuit optoélectronique 10 comprend, du bas vers le haut en figure 3 :

une première électrode 50 ;
un substrat 52, par exemple semiconducteur, comprenant des faces parallèles 54 et 56, la face 54 étant au contact de l'électrode 50 ;
une couche isolante électriquement 58 recouvrant la face 56 et comprenant une ouverture 60 ;
un élément semiconducteur tridimensionnel 62, par exemple un nanofil, un microfil ou une pyramide, s'étendant depuis le substrat 52 dans l'ouverture 60, une couche d'un matériau favorisant la croissance de l'élément semiconducteur tridimensionnel 62 pouvant être interposée entre l'élément semiconducteur tridimensionnel 62 et le substrat 52 ;
une coque 64 recouvrant la paroi extérieure de chaque fil 62, la coque 64 comprenant la couche active ;
une couche isolante électriquement 66 recouvrant la périphérie d'une portion inférieure de chaque coque 64 ;
une couche 68 conductrice électriquement et transparente au rayonnement émis par la couche active et recouvrant la coque 64 ; et

une couche photoluminescente 70 isolante électriquement et recouvrant l'ensemble de la structure.

Selon un mode de réalisation, les couches semiconductrices 32, 38 et l'élément semiconducteur tridimensionnel 62, sont, au moins en partie, formés à partir d'au moins un matériau semiconducteur. Le matériau semiconducteur est choisi parmi le groupe comprenant les composés III-V, les composés II-VI ou les semiconducteurs ou composés du groupe IV.

Selon un mode de réalisation, les couches semiconductrices 32, 38 et l'élément semiconducteur tridimensionnel 62 comprennent un nitrure semiconducteur de formule $Al_xIn_yGa_{(1-x-y)}N$ (x variant de 0 à 1, y variant de 0 à 1 et x+y variant de 0 à 1) pouvant être dopé avec un dopant de type N ou de type P.

Le procédé de croissance des couches semiconductrices 32, 38 et de l'élément semiconducteur tridimensionnel 62 peut être un procédé du type dépôt chimique en phase vapeur (CVD, sigle anglais pour Chemical Vapor Déposition) ou dépôt chimique en phase vapeur aux organométalliques (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Deposition), les procédés hydrothermiques, la pyrolise d'aérosol liquide ou l'électrodépôt.

Selon un mode de réalisation, la couche active peut comprendre des moyens de confinement des porteurs de charge électrique, tels qu'un puits quantique unique ou des puits quantiques multiples. La couche active peut comprendre une pluralité de couches de matériaux selon la formule $In_xGa_{1-x}N$ (x variant de 0 à 1) dans lequel l'énergie de la bande interdite est ajustée en fonction de la proportion d'indium (In). La couche active peut comprendre des puits quantiques multiples comprenant un empilement de couches semiconductrices formant une alternance de puits quantiques et de couches barrières, par exemple une structure InGaN/GaN.

Selon un mode de réalisation, la couche active des diodes électroluminescentes élémentaires émet une lumière bleue, par exemple ayant une longueur d'onde comprise entre 430 nm et 480 nm.

Chaque diode électroluminescente globale $D_i$ comprend au moins une diode électroluminescente élémentaire recouverte d'une couche photoluminescente, par exemple comme cela est représenté sur les figures 2 et 3. De préférence, la couche photoluminescente est commune à l'ensemble des diodes électroluminescentes élémentaires d'une même diode électroluminescente globale $D_i$.

Chaque couche photoluminescente peut comprendre des luminophores. La couche photoluminescente peut comprendre une couche d'un milieu de liaison, par exemple une résine silicone ou une résine époxy, dans laquelle est noyée une poudre de luminophores. La couche photoluminescente d'au moins l'une des diodes électroluminescentes peut comprendre des luminophores de types différents. De préférence, les couches photoluminescentes de toutes diodes électroluminescentes comprennent des luminophores de types différents. La couche photoluminescente d'au moins l'une des diodes électroluminescentes peut correspondre à une couche unique comprenant des luminophores de types différents. A titre de variante, la couche photoluminescente d'au moins l'une des diodes électroluminescentes peut comprendre un empilement de sous-couches photoluminescentes, chaque sous-couche photoluminescente comprenant un luminophore d'un type donné.

Des exemples de luminophores adaptés à émettre un rayonnement lumineux dans le rouge, c'est-à-dire avec une longueur d'onde comprise entre 625 nm et 780 nm, comprennent un luminophore de type nitrure de formule MAlSiN$_x$:Re (avec x variant de 1 à 5) ou un luminophore de formule MD:Re avec :

M choisi parmi le groupe comprenant Ba, Sr, Ca et Mg ;
D choisi parmi le groupe comprenant S, Se et Te ; et
Re choisi parmi le groupe comprenant Eu, Y, La, Ce, Nd, Pm, Sm, Gd, Tb, Dy, Ho, Er, Tm, Yb, Lu, F, Cl, Br et I.

D'autres exemples de luminophores adaptés à émettre un rayonnement lumineux dans le rouge sont : $CaMg_2Al_{16}O_{27}:Mn^{4+}$ et les luminophores de type fluorure, notamment $K_2SiF_6:Mn^{4+}$, $Na_2SiF_6:Mn^{4+}$, $Cs_2SiF_6:Mn^{4+}$, $K_2GeF_6:Mn^{4+}$, $Na_2GeF_6:Mn^{4+}$, $Cs_2GeF_6:Mn^{4+}$, $K_2ZrF_6:Mn^{4+}$, $Na_2ZrF_6:Mn^{4+}$, $Cs_2ZrF_6:Mn^{4+}$, $K_2SnF_6.H_2O:Mn^{4+}$, $Na_2SnF_6:Mn^{4+}$, $Cs_2SnF_6:Mn^{4+}$, $K_2TiF_6:Mn^{4+}$, $Na_2TiF_6:Mn^{4+}$, $Cs_2TiF_6:Mn^{4+}$, $BaSiF_6:Mn^{4+}$, $Na_2GeF_6:Mn^{4+}$, $ZnSiF_6.H_2O:Mn^{4+}$.

Des exemples de luminophores adaptés à émettre un rayonnement lumineux dans le vert, c'est-à-dire avec une longueur d'onde comprise entre 500 nm et 580 nm, comprennent les luminophores de type silicate de formule $M_2SiO_4:Re$, les luminophores de type sulfure de formule $MA_2D_4:Re$, les luminophores de formule β-SiAlON:Re, et les luminophores de type oxyde de formule MA'204:Re' avec :

M choisi parmi le groupe comprenant Ba, Sr, Ca et Mg ;
A choisi parmi le groupe comprenant Ga, Al et In ;
D choisi parmi le groupe comprenant S, Se et Te ;
A' choisi parmi le groupe comprenant Sc, Y, Gd, La, Lu, Al et In ;
Re choisi parmi le groupe comprenant Eu, Y, La, Ce, Nd, Pm, Sm, Gd, Tb, Dy, Ho, Er, Tm, Yb, Lu, F, Cl, Br et I ; et
Re' choisi parmi le groupe comprenant Ce, Nd, Pm, Sm, Tb, Dy, Ho, Er, Tm, Yb, F, Cl, Br et I.

D'autres exemples de luminophores adaptés à émettre un rayonnement lumineux dans le vert sont les luminophores décrits dans le brevet US 9085732, notamment les luminophores de formule $Ca_{8-x-y}A_xEu_yMg_{1-m-n}B_m$-$Mn_n(Si_{1-s}C_sO_4)_4R_2$, où A est au moins un cation divalent comprenant Ca, Sr, Ba, individuellement ou en combinaisons, ou une combinaison de cations +1 et +3, B est Zn ou Cd, ou un ion métallique divalent autre qu'un alcalino-terreux, présent individuellement ou en combinaisons, C est un cation +3, +4 ou +5, comprenant au moins l'un des éléments suivants: Ge, Al, B, Gd, Ga et N, individuellement ou en combinaisons, et R est un anion -1, -2, -3, incluant F, Cl, Br, I, individuellement ou en combinaisons. La valeur de la somme des paramètres x+y est n'importe quelle valeur inférieure à environ 8, et la valeur de la somme des paramètres m+n est n'importe quelle valeur inférieure à environ 1. La valeur du paramètre s est une valeur inférieure à environ 1. Un exemple est le composé $Ca_{8-x}Eu_xMg_{1-y}Mny(SiO_4)_4Cl_2$ où x varie d'environ 0,16 à 0,24 et y varie d'environ 0,3 à 0,5.

D'autres exemples de luminophores adaptés à émettre un rayonnement lumineux dans le vert sont les luminophores décrits dans la publication intitulée "New single-phase, white light-emitting phosphors based on $\delta$-$Gd_2Si_2O_7$ for solid state lighting" aux noms de A.J. Fernández-Carrión, M. Ocaña, J. García-Sevillano, E. Cantelar et A.I. Becerro (Journal of Physical Chemistry C, 2014, 118 (31), pp 18035- 18043), notamment le $\delta$-$Gd_2Si_2O_7$:$Eu^{3+}$,$Tb^{3+}$.

Selon un mode de réalisation, au moins une partie des luminophores peut correspondre à des boîtes quantiques. Une boîte quantique est un cristal de taille nanométrique ayant un coeur et une coque. Le coeur de la boîte quantique peut avoir une taille variant de 2 nm à 100 nm. En ajustant la taille du coeur, la boîte quantique peut former un matériau photoluminescent émettant différentes couleurs, notamment le bleu, le jaune, le vert et le rouge. La structure coeur-coque formant la boîte quantique peut être formée par une hétérojonction d'au moins deux semiconducteurs choisis parmi le groupe II-VI (notamment ZnS, ZnSe, ZnTe, CdS, CdSe, CdTe, HgS, HgSe, HgTe, MgTe), le groupe III-V (notamment GaN, GaP, GaAs, GaSb, InN, InP, InAs, InSb, AlAs, AlP, AlSb, AlS) ou le groupe IV (notamment Ge, Si, Pb) . Un ligand organique utilisant un composé du type acide oléique peut être formé dans la coque externe de la boîte quantique de façon à bloquer les liaisons moléculaires de la coque externe et empêcher l'agglomération des boîtes quantiques, augmenter la dispersion des boîtes quantiques dans une résine, telle qu'une résine silicone ou une résine époxy et/ou améliorer les performances de photoluminescence.

Selon un mode de réalisation, au moins l'une des couches photoluminescentes des diodes électroluminescentes comprend un type de luminophore ayant une constante de déclin supérieure à quelques millisecondes, par exemple 2 ms, de préférence 5 ms. La constante de déclin d'un luminophore est la durée pendant laquelle l'intensité lumineuse émise par le luminophore diminue de 1/e après arrêt du rayonnement incident absorbé par les luminophores. Parmi les luminophores décrits précédemment, des exemples de luminophores ayant une constante de déclin supérieure à quelques millisecondes sont notamment le $\delta$-$Gd_2Si_2O_7$:$Eu^{3+}$,$Tb^{3+}$ et le $K_2SiF_6$:$Mn^{4+}$.

Selon un mode de réalisation, la proportion en poids du luminophore ayant une constante de déclin supérieure à quelques millisecondes est différente pour les couches photoluminescentes d'au moins deux diodes électroluminescentes globales.

Les inventeurs ont mis en évidence qu'une réduction du taux de scintillement FR du circuit optoélectronique peut alors être obtenue. En outre, la réduction du taux de scintillement du circuit optoélectronique peut, de façon avantageuse, être obtenue tout en conservant le même point de couleur perçu par un observateur et la même efficacité lumineuse.

Selon un mode de réalisation, au moins l'une des couches photoluminescentes des diodes électroluminescentes comprend un type de luminophore ayant une constante de déclin inférieure strictement à 2 ms, de préférence inférieure à 1 ms, plus préférentiellement inférieure à 0,5 ms. Parmi les luminophores décrits précédemment, des exemples de luminophores ayant une constante de déclin inférieure à 1 ms sont le SiAlON:$Eu^{2+}$. Tous les exemples de boîtes quantiques décrits précédemment ont une constante de déclin inférieure à 1 ms.

Selon un mode de réalisation, la proportion en poids du luminophore ayant une constante de déclin inférieure à 1 ms est différente pour les couches photoluminescentes d'au moins deux diodes électroluminescentes globales.

Le fait que les compositions des couches photoluminescentes pour au moins deux diodes électroluminescentes globales $D_i$ et $D_j$ sont différentes, avec i différent de j, peut rendre plus simple le procédé de fabrication des couches photoluminescentes pour atteindre une couleur perçue donnée par un observateur.

Selon un mode de réalisation, pour au moins deux diodes électroluminescentes globales $D_i$ et $D_j$, avec i différent de j, dont les couches photoluminescentes comprennent chacune un premier luminophore ayant une constante de déclin supérieure à 2 ms, la proportion dans l'intensité lumineuse de la lumière émise par la diode électroluminescente globale

$D_i$ due au premier luminophore est différente d'au moins 2 %, de préférence d'au moins 5 %, de la proportion dans l'intensité lumineuse de la lumière émise par la diode électroluminescente globale $D_j$ due au premier luminophore.

Selon un mode de réalisation, pour au moins deux diodes électroluminescentes globales $D_i$ et $D_j$, avec i différent de j, la proportion dans l'intensité lumineuse de la lumière émise par la diode électroluminescente globale $D_i$ due à la diode électroluminescente élémentaire ou aux diodes électroluminescentes élémentaires de la diode électroluminescente globale $D_i$, est différente d'au moins 2 %, de préférence d'au moins 5 %, de la proportion dans l'intensité lumineuse de la lumière émise par la diode électroluminescente globale $D_j$ due à la diode électroluminescente élémentaire ou aux diodes électroluminescentes élémentaires de la diode électroluminescente globale $D_j$.

Selon un mode de réalisation, pour au moins deux diodes électroluminescentes globales $D_i$ et $D_j$, avec i différent de j, dont les couches de luminophores comprennent chacune un deuxième luminophore ayant une constante de déclin inférieure à 1 ms en plus du premier luminophore ayant une constante de déclin supérieure à 2 ms, la proportion dans l'intensité lumineuse de la lumière émise par la diode électroluminescente globale $D_i$ due au deuxième luminophore est différente, est différente d'au moins 2 %, de préférence d'au moins 5 %, de la proportion dans l'intensité lumineuse de la lumière émise par la diode électroluminescente globale $D_j$ due au deuxième luminophore.

La figure 4 est un chronogramme de la tension d'alimentation $V_{ALIM}$ dans le cas où la tension alternative $V_{IN}$ correspond à une tension sinusoïdale et pour un exemple dans le cas où le circuit optoélectronique 10 comprend quatre diodes électroluminescentes globales $D_1$, $D_2$, $D_3$ et $D_4$. En figure 4, on a représenté, de façon schématique, des phases $P_1$, $P_2$, $P_3$ et $P_4$. La phase $P_1$ représente la phase de conduction de la diode électroluminescente globale $D_1$. La phase $P2$ représente la phase de conduction de la diode électroluminescente globale $D_2$. La phase $P_3$ représente la phase de conduction de la diode électroluminescente globale $D_3$. La phase $P_4$ représente la phase de conduction de la diode électroluminescente globale $D_4$.

Comme cela apparaît sur la figure 4, les durées d'émission des diodes électroluminescentes globales $D_i$ ne sont pas identiques. Les propriétés, et notamment la couleur, de la lumière perçue par un observateur du circuit optoélectronique 10 vont dépendre notamment des compositions différentes des couches de luminophores des diodes électroluminescentes globales et des durées d'émission différentes de chaque diode électroluminescente globale.

Des première et deuxième simulations ont été réalisées. Pour ces simulations, le circuit optoélectronique 10 comprenait deux diodes électroluminescentes globales $D_1$ et $D_2$. Chaque diode électroluminescente globale comprenait le même nombre de diodes électroluminescentes élémentaires qui émettaient toute une lumière bleue à une longueur d'onde de 455 nm. La couche photoluminescente de chaque diode électroluminescente globale comprenait un luminophore adapté à émettre une lumière rouge, par exemple correspondant à un point de couleur de coordonnées chromatiques x=0,681 et y=0,296 dans l'espace de couleur CIE 1931, appelé luminophore rouge, et ayant une constante de déclin de 8 ms. La couche photoluminescente de chaque diode électroluminescente globale pouvait, en outre, comprendre un luminophore adapté à émettre une lumière verte, par exemple correspondant à un point de couleur de coordonnées chromatiques x=0,356 et y=0,576 dans l'espace de couleur CIE 1931, appelé luminophore vert, et ayant une constante de déclin inférieure à 1 ms.

Une première simulation de comparaison a été réalisée dans laquelle les couches de luminophores des deux diodes électroluminescentes globales $D_1$ et $D_2$ avaient la même composition. Les proportions de luminophores rouges et de luminophores verts étaient telles que, en régime stabilisé au cours de chaque phase d'émission, le rayonnement de la lumière émise par chaque diode électroluminescente globale et perçue par un observateur comprenait 15 % de lumière bleue émise par les diodes électroluminescentes élémentaires, 40 % de lumière rouge émise par les luminophores rouges et 45 % de lumière verte émise par les luminophores verts.

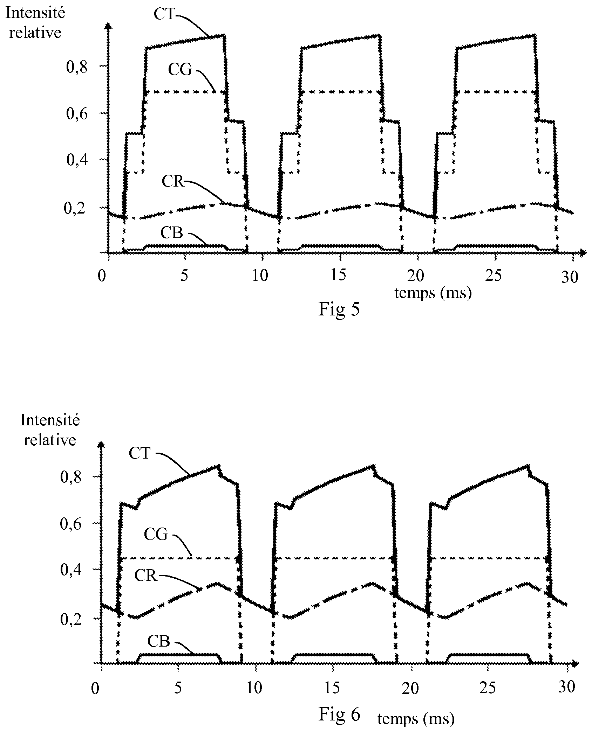

La figure 5 représente, pour la première simulation, des courbes d'évolution en fonction du temps de l'intensité lumineuse relative de la lumière émise par le circuit optoélectronique 10 (courbe CT) avec les proportions de lumière bleue (courbe CB), de lumière rouge (courbe CR), et de lumière verte (courbe CG) au cours de trois cycle d'évolution de la tension $V_{ALIM}$.

La couleur perçue par un observateur correspondait à un blanc chaud à 3100 K. Le taux de scintillement du circuit optoélectronique 10 pour la première simulation était de 72 %. L'efficacité lumineuse du circuit optoélectronique 10, qui est égale au rapport entre le flux lumineux émis par le circuit optoélectronique 10 et la puissance électrique consommée par le circuit optoélectronique 10, était de 100 lm/W. La présence des luminophores ayant une constante de déclin supérieure à 2 ms permet de poursuivre l'émission d'un rayonnement par le circuit optoélectronique 10 même lorsqu'aucune diode électroluminescente élémentaire n'est activée. Ceci permet de réduire le taux de scintillement du circuit optoélectronique 10.

Une deuxième simulation a été réalisée dans laquelle les couches de luminophores des deux diodes électroluminescentes globales $D_1$ et $D_2$ avaient des compositions différentes. Les proportions de luminophores rouges et de luminophores verts étaient telles que, en régime stabilisé, l'intensité lumineuse de la lumière émise par la diode électroluminescente globale $D_1$ comprenait 12 % de lumière bleue, 14 % de lumière rouge et 74 % de lumière verte et que, l'intensité lumineuse de la lumière émise par la diode électroluminescente globale $D_2$ comprenait 20 % de lumière bleue, 80 % de lumière rouge et 0 % de lumière verte.

La figure 6 représente des courbes d'évolution analogues à la figure 5 pour la deuxième simulation.

La couleur perçue par un observateur correspondait à un blanc chaud à 3100 K. Le taux de scintillement du circuit optoélectronique 10 pour la deuxième simulation était de 57,4 %. L'efficacité lumineuse du circuit optoélectronique 10 était de 100 lm/W.

Le taux de scintillement du circuit optoélectronique a donc été réduit tout en conservant le même point de couleur perçu par un observateur et la même efficacité lumineuse.

Des modes de réalisation particuliers ont été décrits. Diverses variantes et modifications apparaîtront à l'homme de l'art. En particulier, bien que des modes de réalisation aient été décrits pour un schéma électrique particulier du circuit optoélectronique 10, il est clair que le circuit optoélectronique, et en particulier le dispositif 24 de commutation des diodes électroluminescentes, peut avoir une structure différente de la structure représentée en figure 1. A titre d'exemple, la structure du circuit optoélectronique peut correspondre à celle décrite dans les demandes de brevet WO2016/001201, WO2016/005448 et WO2016/108022.

**Revendications**

1. Circuit optoélectronique (10) destiné à recevoir une tension variable ($V_{ALIM}$) contenant une alternance de phases croissantes et décroissantes, le circuit optoélectronique comprenant des diodes électroluminescentes ($D_i$) et un dispositif de commutation (24) adapté à permettre ou interrompre la circulation d'un courant ($I_{CS}$) dans chaque diode électroluminescente, les diodes électroluminescentes comprenant une première diode électroluminescente recouverte d'une première couche photoluminescente et une deuxième diode électroluminescente recouverte d'une deuxième couche photoluminescente, le circuit optoélectronique comprenant un premier ensemble comprenant la première diode électroluminescente recouverte de la première couche photoluminescente et adapté à émettre un premier rayonnement et un deuxième ensemble comprenant la deuxième diode électroluminescente recouverte de la deuxième couche photoluminescente et adapté à émettre un deuxième rayonnement, les première et deuxième diodes électroluminescentes étant adaptées à émettre un troisième rayonnement, les première et deuxième couches photoluminescentes comprenant chacune au moins un premier luminophore ayant une première constante de déclin et adapté à absorber en partie le troisième rayonnement et à émettre un quatrième rayonnement différent du troisième rayonnement, la première et/ou la deuxième couche photoluminescente comprenant en outre au moins un deuxième luminophore ayant une deuxième constante de déclin différente de la première constante de déclin, le dispositif de commutation (24) étant adapté à connecter les première et deuxième diodes électroluminescentes ($D_i$) selon un premier ordre au cours de chaque phase croissante de la tension variable ($V_{ALIM}$) et un deuxième ordre au cours de chaque phase décroissante de la tension variable, **caractérisé en ce que** l'intensité relative du quatrième rayonnement dans le premier rayonnement est différente de l'intensité relative du quatrième rayonnement dans le deuxième rayonnement.

2. Circuit optoélectronique selon la revendication 1, dans lequel la première constante de déclin est supérieure à 2 ms.

3. Circuit optoélectronique selon la revendication 1 ou 2, dans lequel la deuxième constante de déclin est inférieure strictement à 2 ms.

4. Circuit optoélectronique selon l'une quelconque des revendications 1 à 3, dans lequel la proportion dans l'intensité lumineuse de la lumière émise par le premier ensemble due au premier luminophore est différente d'au moins 2 %, de préférence d'au moins 5 %, de la proportion dans l'intensité lumineuse de la lumière émise par le deuxième ensemble due au premier luminophore.

5. Circuit optoélectronique selon l'une quelconque des revendications 1 à 4, dans lequel la première couche photoluminescente comprend au moins le deuxième luminophore adapté à absorber en partie le troisième rayonnement et à émettre un cinquième rayonnement différent du troisième rayonnement.

6. Circuit optoélectronique selon la revendication 5, dans lequel la deuxième couche photoluminescente comprend au moins le deuxième luminophore.

7. Circuit optoélectronique selon la revendication 5 ou 6, dans lequel l'intensité relative du cinquième rayonnement dans le premier rayonnement est différente de l'intensité relative du cinquième rayonnement dans le deuxième rayonnement.

8. Circuit optoélectronique selon la revendication 7, dans lequel la proportion dans l'intensité lumineuse de la lumière émise par le premier ensemble due au deuxième luminophore est différente d'au moins 2 %, de préférence d'au moins 5 %, de la proportion dans l'intensité lumineuse de la lumière émise par le deuxième ensemble due au deuxième luminophore.

9. Circuit optoélectronique selon l'une quelconque des revendications 1 à 8, dans lequel le dispositif de commutation (24) est adapté à connecter les diodes électroluminescentes (D$_i$) selon un premier ordre au cours de chaque phase croissante de la tension variable (V$_{ALIM}$) et un deuxième ordre au cours de chaque phase décroissante de la tension variable.

10. Circuit optoélectronique selon l'une quelconque des revendications 1 à 9, dans lequel le dispositif de commutation (24) comprend au moins un interrupteur (SW$_i$) pour chaque diode électroluminescente (D$_i$), le dispositif de commutation (24) étant adapté à transmettre des signaux de commande binaires (S$_i$) pour l'ouverture ou la fermeture des interrupteurs.

11. Circuit optoélectronique selon la revendication 10, comprenant une source de courant (22) et dans lequel, pour chaque diode électroluminescente (D$_i$), l'interrupteur (SW$_i$) relie la source de courant à ladite diode électroluminescente.

**Patentansprüche**

1. Optoelektronische Schaltung (10), die dazu bestimmt ist, eine variable Spannung (V$_{ALIM}$) zu empfangen, die einen Wechsel von ansteigenden und abfallenden Phasen enthält, wobei die optoelektronische Schaltung Leuchtdioden (D$_i$) und eine Schaltvorrichtung (24) aufweist, die in der Lage ist, das Fließen eines Stroms (I$_{CS}$) durch jede Leuchtdiode zuzulassen oder zu unterbrechen, wobei die Leuchtdioden eine erste Leuchtdiode aufweisen, die mit einer ersten photolumineszenten Schicht bedeckt ist, und eine zweite Leuchtdiode, die mit einer zweiten photolumineszenten Schicht bedeckt ist, die optoelektronische Schaltung eine erste Baugruppe aufweist, die die erste Leuchtdiode aufweist, die mit der ersten Photolumineszenzschicht bedeckt ist und eine erste Strahlung aussenden kann, und eine zweite Baugruppe aufweist, die die zweite Leuchtdiode aufweist, die mit der zweiten Photolumineszenzschicht bedeckt ist und eine zweite Strahlung aussenden kann, die erste und die zweite Leuchtdiode fähig sind, eine dritte Strahlung zu emittieren, wobei die erste und die zweite Photolumineszenzschicht jeweils mindestens einen ersten Luminophor mit einer ersten Zerfallskonstante aufweisen und fähig sind, die dritte Strahlung teilweise zu absorbieren und eine vierte Strahlung zu emittieren, die sich von der dritten Strahlung unterscheidet, wobei die erste und/oder die zweite Photolumineszenzschicht außerdem mindestens einen zweiten Luminophor mit einer zweiten Zerfallskonstante aufweisen, die sich von der ersten Zerfallskonstante unterscheidet, wobei die Schaltvorrichtung (24) in der Lage ist, die erste und die zweite Leuchtdiode (D$_i$) gemäß einer ersten Reihenfolge während jeder Anstiegsphase der variablen Spannung (V$_{ALIM}$) und einer zweiten Reihenfolge während jeder Abfallphase der variablen Spannung zu verbinden, **dadurch gekennzeichnet, dass** die relative Intensität der vierten Strahlung in der ersten Strahlung von der relativen Intensität der vierten Strahlung in der zweiten Strahlung verschieden ist.

2. Optoelektronische Schaltung nach Anspruch 1, wobei die erste Abklingkonstante größer als 2 ms ist.

3. Optoelektronische Schaltung nach Anspruch 1 oder 2, bei der die zweite Abklingkonstante kleiner als 2 ms ist.

4. Optoelektronische Schaltung nach einem der Ansprüche 1 bis 3, wobei sich der Anteil der Lichtintensität des von der ersten Anordnung aufgrund des ersten Luminophors emittierten Lichts um mindestens 2%, vorzugsweise um mindestens 5%, von dem Anteil der Lichtintensität des von der zweiten Anordnung aufgrund des ersten Luminophors emittierten Lichts unterscheidet.

5. Optoelektronische Schaltung nach einem der Ansprüche 1 bis 4, **dadurch gekennzeichnet, dass** die erste photolumineszente Schicht mindestens den zweiten Luminophor aufweist, der in der Lage ist, die dritte Strahlung teilweise zu absorbieren und eine fünfte, von der dritten Strahlung verschiedene Strahlung zu emittieren.

6. Optoelektronische Schaltung nach Anspruch 5, wobei die zweite photolumineszente Schicht mindestens den zweiten Luminophor aufweist.

7. Optoelektronische Schaltung nach Anspruch 5 oder 6, wobei die relative Intensität der fünften Strahlung in der ersten Strahlung von der relativen Intensität der fünften Strahlung in der zweiten Strahlung verschieden ist.

8. Optoelektronische Schaltung nach Anspruch 7, wobei sich der Anteil der Lichtintensität des von der ersten Anordnung aufgrund des zweiten Luminophors emittierten Lichts um mindestens 2%, vorzugsweise um mindestens 5%, von dem Anteil der Lichtintensität des von der zweiten Anordnung aufgrund des zweiten Luminophors emittierten Lichts unterscheidet.

9. Optoelektronische Schaltung nach einem der Ansprüche 1 bis 8, wobei die Schaltvorrichtung (24) in der Lage ist, die Leuchtdioden ($D_i$) während jeder Anstiegsphase der variablen Spannung ($V_{ALIM}$) in einer ersten Reihenfolge und während jeder Abfallphase der variablen Spannung in einer zweiten Reihenfolge zu schalten.

10. Optoelektronische Schaltung nach einem der Ansprüche 1 bis 9, wobei die Schaltvorrichtung (24) mindestens einen Schalter ($SW_i$) für jede Leuchtdiode ($D_i$) aufweist, wobei die Schaltvorrichtung (24) in der Lage ist, binäre Steuersignale ($S_i$) für das Ausschalten oder das Einschalten der Schalter zu übertragen.

11. Optoelektronische Schaltung nach Anspruch 10, mit einer Stromquelle (22), wobei für jede Leuchtdiode ($D_i$) der Schalter ($SW_i$) die Stromquelle mit der Leuchtdiode koppelt.


**Claims**

1. An optoelectronic circuit (10) intended to receive a variable voltage ($V_{ALIM}$) containing an alternation of rising and falling phases, the optoelectronic circuit comprising light-emitting diodes ($D_i$) and a switching device (24) capable of allowing or of interrupting the flowing of a current ($I_{CS}$) through each light-emitting diode, the light-emitting diodes comprising a first light-emitting diode covered with a first photoluminescent layer and a second light-emitting diode covered with a second photoluminescent layer, the optoelectronic circuit comprising a first assembly comprising the first light-emitting diode covered with the first photoluminescent layer and capable of emitting a first radiation and a second assembly comprising the second light-emitting diode covered with the second photoluminescent layer and capable of emitting a second radiation, the first and second light-emitting diodes being capable of emitting a third radiation, the first and second photoluminescent layers comprising each at least one first luminophore having a first decay constant and capable of partly absorbing the third radiation and emitting a fourth radiation different from the third radiation, the first and/or the second photoluminescent layers further comprising at least one second luminophore having a second decay constant different from the first decay constant, the switching device (24) being capable of connecting the first and second light-emitting diodes ($D_i$) according to a first order during each rising phase of the variable voltage ($V_{ALIM}$) and a second order during each falling phase of the variable voltage, **characterized in that** the relative intensity of the fourth radiation in the first radiation is different from the relative intensity of the fourth radiation in the second radiation.

2. The optoelectronic circuit according to claim 1, wherein the first decay constant is greater than 2 ms.

3. The optoelectronic circuit according to claim 1 or 2, wherein the second decay constant is smaller than 2 ms.

4. The optoelectronic circuit according to any of claims 1 to 3, wherein the proportion in the light intensity of the light emitted by the first assembly due to the first luminophore is different by at least 2%, preferably by at least 5%, from the proportion in the light intensity of the light emitted by the second assembly due to the first luminophore.

5. The optoelectronic circuit according to any of claims 1 to 4, wherein the first photoluminescent layer comprises at least the second luminophore capable of partly absorbing the third radiation and of emitting a fifth radiation different from the third radiation.

6. The optoelectronic circuit according to claim 5, wherein the second photoluminescent layer comprises at least the second luminophore.

7. The optoelectronic circuit according to claim 5 or 6, wherein the relative intensity of the fifth radiation in the first radiation is different from the relative intensity of the fifth radiation in the second radiation.

8. The optoelectronic circuit according to claim 7, wherein the proportion in the light intensity of the light emitted by the first assembly due to the second luminophore is different by at least 2%, preferably by at least 5%, from the proportion in the light intensity of the light emitted by the second assembly due to the second luminophore.

9. The optoelectronic circuit according to any of claims 1 to 8, wherein the switching device (24) is capable of connecting the light-emitting diodes ($D_i$) according to a first order during each rising phase of the variable voltage ($V_{ALIM}$) and a second order during each falling phase of the variable voltage.

10. The optoelectronic circuit according to any of claims 1 to 9, wherein the switching device (24) comprises at least one switch ($SW_i$) for each light-emitting diode ($D_i$), the switching device (24) being capable of transmitting binary control signals ($S_i$) for the turning off or the turning on of the switches.

11. The optoelectronic circuit according to claim 10, comprising a current source (22) and wherein, for each light-emitting diode ($D_i$), the switch ($SW_i$) couples the current source to said light-emitting diode.

Fig 1

Fig 2

Fig 3

Fig 4

Fig 5

Fig 6

**EP 3 804 468 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2016198348 A
- US 8395332 B
- US 2014264402 A
- FR 2995729
- FR 2997558
- US 9085732 B
- WO 2016001201 A
- WO 2016005448 A
- WO 2016108022 A

**Littérature non-brevet citée dans la description**

- **A.J. FERNÁNDEZ-CARRIÓN ; M. OCAÑA ; J. GARCÍA-SEVILLANO ; E. CANTELAR ; A.I. BECERRO.** *Journal of Physical Chemistry C,* 2014, vol. 118 (31), 18035-18043